# EUROPÄISCHE PATENTSCHRIFT

(11) **EP 2 249 393 B1**
(45) Veröffentlichungstag und Bekanntmachung des Hinweises auf die Patenterteilung: **28.12.2016**
(21) Anmeldenummer: 10161909.6
(22) Anmeldetag: 04.05.2010
(51) Int. Cl.: H01L 31/02, H02H 11/00, H02H 5/00, H02H 3/02

(54) **Schaltungsanordnung**
Switching assembly
Agencement de circuit

(30) Priorität: 04.05.2009 DE 102009019831
(43) Veröffentlichungstag der Anmeldung: 10.11.2010
(73) Patentinhaber: Robert Bosch GmbH, 70442 Stuttgart (DE)
(72) Erfinder: Andresen, Stefan, 61203 Reichelsheim (DE); Schütz, Jean, 68809 Neulußheim (DE)

(56) Entgegenhaltungen:
- EP-A2- 2 037 559
- EP-A2- 2 061 052
- DE-A1- 19 745 074
- DE-A1-102005 018 173
- DE-A1-102005 061 532
- DE-U1- 7 602 660

## Beschreibung

Die vorliegende Erfindung betrifft eine Schaltungsanordnung zum elektrischen Koppeln einer Gleichstromquelle mit einem Gleichstromverbraucher sowie ein Verfahren zum Unterbrechen einer Gleichstromverbindung zwischen einem Ausgang einer Gleichstromquelle und einem Eingang eines Gleichstromverbrauchers. Weiterhin betrifft die Erfindung die Verwendung eines Trenners zum Unterbrechen einer Gleichstromverbindung.

Eine Schaltungsanordnung nach dem Oberbegriff des Anspruches 1 ist aus der DE 10 2005 018 173 bekannt.

Solargeneratoren erzeugen einen Gleichstrom, der an einen angeschlossenen Verbraucher übertragen wird. Dabei erzeugen die Solargeneratoren Strom, sobald ein Verbraucher angeschlossen ist und Strom abnehmen kann und ausreichend Einstrahlung vorhanden ist. Es ist daher notwendig, eine Abschaltvorrichtung vorzusehen, die im Fehlerfall den Solargenerator vom Verbraucher trennen kann.

Aus dem Stand der Technik sind diverse Lösungen bekannt, die auf DC-Schaltern oder Schaltungsanordnungen zur Leistungsreduktion über gepulste Halbleiter beruhen. Aus der EP 1 657 797 ist beispielsweise eine Schaltungsanordnung mit Solargeneratoren und angeschlossenem Wechselrichter bekannt, die im Fehlerfall, wenn der Wechselrichter von dem Solargenerator getrennt werden soll, den Stromkreis vom Solargenerator zum Wechselrichter und zurück mittels eines Taktmoduls allmählich unterbricht und dadurch den Solargenerator in einen Leerlaufzustand versetzt. Sobald dieser Leerlaufzustand eingetreten ist, fließt kein Strom mehr zwischen Solargenerator und Wechselrichter und die Verbindung kann getrennt werden.

Nachteilig hierbei ist der verhältnismäßig große und komplizierte Aufwand, ein solches Abschalten vorzubereiten. Zudem muss der vollständige Strom auch im Normalbetrieb, also die überwiegende Zeit über das Taktmodul fließen. Hierdurch entstehen insbesondere Wärmeverluste in dem Taktmodul.

Der Erfindung liegt somit die Aufgabe zugrunde, wenigstens eins der genannten Probleme möglichst zu verringern oder zu beheben. Insbesondere sollte eine vereinfachte Schaltungsanordnung und/oder eine Schaltungsanordnung mit weniger Verlusten im laufenden Betrieb und/oder zumindest eine alternative Schaltungsanordnung angegeben werden.

Erfindungsgemäß wird eine Schaltungsanordnung nach Anspruch 1 vorgeschlagen.

Die erfindungsgemäße Schaltungsanordnung ist dazu vorbereitet, eine elektrische Gleichstromquelle mit einem Gleichstromverbraucher zu koppeln. Es sind zwei Stromeingangsknoten vorgesehen, an denen der von der Gleichstromquelle erzeugte Gleichstrom eingegeben wird. Unter dem Eingeben eines Stromes ist hierbei ein positiver Strom bei positiver Spannung z. B. am ersten Stromeingangsknoten und ein negativer Strom bei negativer Spannung am zweiten Stromeingangsknoten zu verstehen. Eine positive bzw. negative Spannung bezieht sich grundsätzlich auf eine mittlere Spannung zwischen dem Spannungspotential des ersten Stromeingangsknotens und des Spannungspotentials des zweiten Stromeingangsknotens.

Weiterhin sind zwei Stromausgangsknoten zum Abgeben des von der Gleichstromquelle erzeugten Gleichstroms an den Gleichstromverbraucher vorgesehen. Im Betrieb fließt der erzeugte Strom somit im Wesentlichen von der Gleichstromquelle zum Gleichstromverbraucher, nämlich von der Gleichstromquelle bei positiver Spannung zum ersten Stromeingangsknoten, von dort zum ersten Stromausgangsknoten und weiter zum Gleichstromverbraucher. Vom Gleichstromverbraucher fließt der Strom bei negativer Spannung zum zweiten Stromausgangsknoten und weiter zum zweiten Stromeingangsknoten und schließlich zur Gleichstromquelle zurück, um einen geschlossenen Stromkreis zu bilden.

Weiterhin ist ein Trennmittel zum Trennen des elektrischen Stromkreises vorgesehen. Das Trennmittel ist zwischen den Stromeingangsknoten und Stromausgangsknoten angeschlossen. Dabei kann eine Verbindung zwischen erstem Stromeingangsknoten und erstem Stromausgangsknoten oder auch zwischen zweitem Stromeingangsknoten und zweiten Stromausgangsknoten erfolgen. Ebenso kann das Trennmittel dazu vorgesehen sein, beide oben genannten Trennungen insbesondere zugleich vorzunehmen.

Zwischen dem ersten Stromeingangsknoten und dem zweiten Stromeingangsknoten ist ein Hilfsschaltmittel angeschlossen, um den ersten und zweiten Stromeingangsknoten kurzzuschließen. Wird dieses Hilfsschaltmittel zum Kurzschließen geschlossen, ist somit die Gleichstromquelle kurzgeschlossen. Hierdurch kann erreicht werden, dass der Strom zum Verbraucher auf null gesenkt wird. Die Gleichstromquelle erzeugt zwar weiterhin Gleichstrom, dieser fließt aufgrund des Kurzschlusses aber nicht mehr oder allenfalls in sehr geringen Mengen zum Verbraucher.

Das Trennmittel kann nun öffnen, um eine elektrische Verbindung zwischen erstem Stromeingangsknoten und erstem Stromausgangsknoten bzw. zweiten Stromeingangsknoten und zweiten Stromausgangsknoten zu unterbrechen. Für das Trennmittel tritt somit nicht das bekannte Problem auf, auch einen insbesondere großen Gleichstrom zu unterbrechen. Vielmehr kann es im stromlosen Zustand schalten. Entsprechend kann ein kostengünstiges Trennmittel verwendet werden, das nicht zum Schalten unter Last geeignet zu sein braucht.

Bevorzugt bildet die Gleichstromquelle einen Teil der Schaltungsanordnung. Vorzugsweise wird ein Solargenerator als Gleichstromquelle verwendet, um den elektrischen Gleichstrom zu erzeugen und an den Stromeingangsknoten einzugeben. Ein Solargenerator, also insbesondere ein Array von Photovoltaikzellen erzeugt einen Gleichstrom, sobald ausreichend Bestrahlung vorhanden ist und ein Verbraucher angeschlossen ist. Dabei ist ein Solargenerator üblicherweise kurzschlussfest und kann somit erfindungsgemäß durch das Hilfsschaltmittel kurzgeschlossen werden.

Vorzugsweise bildet der elektrische Gleichstromverbraucher einen Teil der Schaltungsanordnung. Vorzugsweise wird als Gleichstromverbraucher ein Wechselrichter verwendet zum Wandeln des Gleichstroms in einen Wechselstrom zum Einspeisen in ein elektrisches Wechselstromnetz. Somit kann auf günstige Art und Weise ein Solargenerator trennbar mit einem Wechselrichter und darüber mit einem elektrischen Wechselstromnetz gekoppelt sein, um die oder einen Großteil der im Solargenerator in Form von Gleichstrom erzeugte elektrische Energie über den Wechselrichter in ein elektrisches Wechselstromnetz einzuspeisen. Sollte beispielsweise aufgrund eines Fehlers der Gleichstromverbraucher vom Solargenerator getrennt werden müssen, wird zunächst der Hilfsschalter geschlossen und der vom Solargenerator erzeugte Gleichstrom wird als Kurschlussstrom fließen und damit nicht oder allenfalls in minimalen Teilen den Gleichstromverbraucher erreichen. Eine Verbindung zwischen Solargenerator und Verbraucher, insbesondere Wechselrichter, kann nun im Grunde lastfrei getrennt werden.

Vorzugsweise wird als Trennmittel ein Trenner, insbesondere ein AC-Trenner verwendet. Unter einem Trenner wird ein Bauteil verstanden, das elektrische Stromkreise bei geringem Strom oder sogar im stromlosen Zustand trennt. Unter geringem Strom ist in diesem Zusammenhang ein Strom zu verstehen, der zumindest kleiner, insbesondere wesentlich kleiner als der Nennstrom der Schaltung an der betreffenden Stelle ist. Bei Verwendung eines Solargenerators kann hierbei der Nennstrom des Solargenerators zugrunde gelegt werden.

Ein AC-Trenner ist für eine Wechselspannungsanwendung zum Trennen des Wechselstroms vorgesehen. Bei dem Schalten eines Wechselstroms tritt möglicherweise nicht das Problem eines Lichtbogens auf.

Werden Stromkreise unter Last getrennt, entsteht beim Trennen im Schalter ein Lichtbogen. Die Löschung des Lichtbogens ist das Hauptproblem des Lastschalters. Hierzu werden je nach Schaltvermögen entsprechende technische Maßnahmen getroffen. Das Nenn-Einschaltvermögen und Nenn-Ausschaltvermögen liegt bei Lastschaltern etwa beim doppelten Nennstrom. Der typische Nennstrom kann bis 100 A oder sogar höher reichen. Insbesondere können Nennströme im Bereich von 10 A bis 100 A und insbesondere im Bereich von 20 A bis 100 A liegen. Durch das Kurzschließen des Solargenerators - oder anderer Gleichstromquelle - braucht somit nur ein kostengünstiger Trenner, insbesondere AC-Trenner vorgesehen zu sein. Die Verwendung eines teuren, aufwändigen und auf den jeweiligen Nennstrom abgestimmten Lastschalters kann vermieden werden.

Vorzugsweise umfasst das Hilfsschaltmittel wenigstens einen Halbleiterschalter, insbesondere einen IGBT, Thyristor oder MOSFET. Bevorzugt ist das Hilfsschaltmittel ein Halbleiterschalter, insbesondere ein IGBT, Thyristor oder MOSFET. Solche Halbleiterschalter können schnell, elektronisch und damit grundsätzlich auf einfache Weise geschaltet werden, sofern eine entsprechende Ansteuerelektronik vorliegt. Ein grundsätzlicher Nachteil eines Halbleiterschalters könnte das Auftreten von Verlustleistung an dem Halbleiterschalter sein. Erfindungsgemäß ist das Hilfsschaltmittel bzw. der Halbleiterschalter während des normalen Betriebes aber geöffnet. In diesem Zustand fällt keine oder keine nennenswerte Verlustleistung an dem Halbleiterschalter ab. Für die möglichst kurz zu haltenden Zustände, in denen der Halbleiterschalter geschlossen ist, kann die abfallende Verlustleistung in Kauf genommen werden.

Wenn im Fehlerfall das Hilfsschaltmittel geschlossen und die Verbindung zwischen Solargenerator und Wechselrichter - bzw. Gleichstromquelle und Gleichstromverbraucher - unterbrochen ist, kann das Hilfsschaltmittel wieder geöffnet werden, um den Solargenerator vom Kurzschlusszustand in den Leerlaufzustand zu versetzen. Das Öffnen eines Halbleiterschalters unter Strom durch Unterbrechen des Stromes ist grundsätzlich möglich. Probleme eines Lichtbogens können bei Halbleiterschaltern naturgemäß nicht auftreten. Bei Verwendung eines Thyristors müsste dieser zwar gezielt gelöscht werden, jedoch sind hierfür generell Schaltungs- und Ansteuervarianten hinlänglich bekannt.

Vorzugsweise ist zumindest zwischen einem Stromeingangsknoten und Stromausgangsknoten ein Gleichrichtmittel, insbesondere eine Diode angeordnet. Die Diode ist so gerichtet, dass der von der Gleichstromquelle erzeugte Strom durch sie hindurch fließt, nämlich von der Gleichstromquelle zum Gleichstromverbraucher bei positiver Spannung oder vom Gleichstromverbraucher zur Gleichstromquelle bei negativer Spannung. Hierdurch wird erreicht, dass beim Schließen des Hilfsschaltmittels sich die Stromrichtung nicht umkehren kann und der Gleichstromverbraucher nicht plötzlich zur Gleichstromquelle wird und wieder Energie abgibt. Insbesondere kann dies bei Verwendung eines Wechselrichters mit Gleichspannungszwischenkreis ein Problem sein. Beim Schließen des Hilfsschaltmittels könnte der Gleichspannungszwischenkreis, insbesondere auch dort vorhandene Gleichspannungszwischenkreiskondensatoren kurzgeschlossen werden. Dies würde zu erheblichen Rückströmen führen. Durch die Verwendung des Gleichrichtmittels, insbesondere der Diode, wird dies verhindert.

Um Verluste durch dieses Gleichrichtmittel, insbesondere die Diode, im Betrieb zu verringern, können ein oder mehrere parallel zum Gleichrichtmittel geschaltete Halbleiterschalter vorgesehen sein. Diese können im normalen Betrieb geschlossen sein und das Gleichrichtmittel dadurch entlasten. Im Fehlerfall können sie geöffnet werden, bevor das Hilfsschaltmittel geschlossen wird oder etwa zeitgleich damit. Das Öffnen solcher parallel zum Gleichrichtmittel geschalteter Halbleiterschalter unter Last stellt kein nennenswertes Problem dar, weil der betreffende Strom durch das Gleichrichtmittel weiter fließt und somit durch besagtes Öffnen der Halbleiterschalter nicht unterbrochen wird.

Erfindungsgemäß wird zudem ein Verfahren zum Unterbrechen einer Gleichstromverbindung zwischen einem Ausgang einer Gleichstromquelle und einem Eingang eines Gleichstromverbrauchers vorgeschlagen, die die folgenden Schritte in der folgenden Reihenfolge umfasst:
Zunächst wird der Ausgang der Gleichstromquelle mittels eines Hilfsschaltmittels kurzgeschlossen, so dass am Ausgang der Gleichstromquelle ein Kurzschlussstrom fließt und die Gleichstromverbindung zum Verbraucher stromlos wird. Etwaige kleinere Ströme können vernachlässigt werden.

Anschließend wird die Gleichstromverbindung zwischen der Gleichstromquelle wie beispielsweise einem Solargenerator und dem Gleichstromverbraucher wie beispielsweise einen Wechselrichter unterbrochen.

Im nächsten Schritt kann schließlich das Hilfsschaltmittel wieder geöffnet werden, um den Kurzschlussstrom am Ausgang der Gleichstromquelle zu unterbinden. Insbesondere wird eine Belastung des Hilfsschaltmittels durch einen Dauerstrom hierdurch vermieden. Anschließend kann auch - falls gewünscht - die Gleichstromquelle wie ein Solargenerator von dem Gleichstromverbraucher wie einem Wechselrichter mechanisch getrennt werden.

Vorzugsweise wird ein erfindungsgemäßes Verfahren mit einer erfindungsgemäßen Schaltungsanordnung ausgeführt.

Erfindungsgemäß kann somit ein AC-Trenner, der zum Trennen einer Wechselspannungs- bzw. Wechselstromverbindung vorgesehen ist, zum Unterbrechen einer Gleichstromverbindung zwischen einer Gleichstromquelle und einem Gleichstromverbraucher verwendet werden. Dies wird möglich durch das Vorsehen eines Hilfsschalters zum Kurzschließen des Ausgangs der Gleichstromquelle.

Vorzugsweise wird ein AC-Trenner zum Unterbrechen einer Gleichstromverbindung in einer erfindungsgemäßen Schaltungsanordnung verwendet, insbesondere in einer Schaltungsanordnung in der ein Solargenerator mit einem Wechselrichter derart gekoppelt ist, dass der Solargenerator den Wechselrichter mit dem Gleichstrom versorgt, so dass der Wechselrichter einen Wechselstrom zum Einspeisen in ein Wechselstromnetz bereitstellen kann.

Nachfolgend wird die Erfindung anhand eines Ausführungsbeispiels unter Bezugnahme auf die begleitende Figur beschrieben.

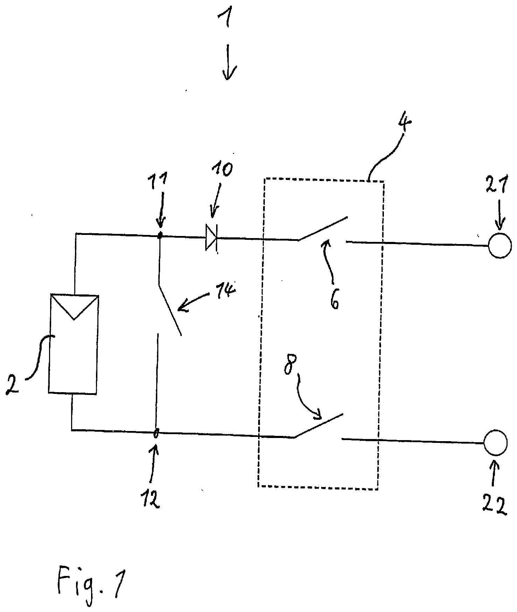

Figur 1 zeigt eine erfindungsgemäße Schaltungsanordnung mit einem Solargenerator.

Die Schaltungsanordnung 1 gemäß Figur 1 weist einen Solargenerator 2 und ein Trennmittel 4 auf. Der Solargenerator 2, der hier die Gleichstromquelle bildet, ist über einen ersten und zweiten Stromeingangsknoten 11 bzw. 12 mit dem Trennmittel 4 elektrisch verbunden. Zum Anschließen eines Gleichstromverbrauchers ist ein erster und zweiter Stromausgangsknoten 21 bzw. 22 vorgesehen. Das Trennmittel 4 weist einen ersten und zweiten Trennschalter 6 bzw. 8 auf. Die beiden Trennschalter 6 und 8 sind geöffnet dargestellt und unterbrechen somit die Verbindung zwischen dem ersten Stromeingangsknoten 11 und dem ersten Stromausgangsknoten 21 bzw. zwischen dem zweiten Stromeingangsknoten 12 und dem zweiten Stromausgangsknoten 22.

Außerdem ist ein Gleichrichtmittel 10 mit einer Durchlassrichtung so vorgesehen, dass ein Strom vom ersten Stromeingangsknoten 11 zum ersten Stromausgangsknoten 21 durchgelassen, in entgegengesetzter Richtung aber gesperrt wird. Weiterhin ist ein Hilfsschaltmittel 14 vorgesehen, um den ersten Stromeingangsknoten mit dem zweiten Stromeingangsknoten elektrisch zu verbinden, um den Solargenerator 2 kurzschließen zu können.

Im Betrieb, wenn also ein Gleichstromverbraucher am ersten und zweiten Stromausgangsknoten 21, 22 angeschlossen ist, sind die beiden Trennschalter 6 und 8 geschlossen. Das Hilfsschaltmittel 14 ist geöffnet. Von dem Solargenerator 2 fließt somit ein Strom über die Diode 10, den ersten Trennschalter 6 zum ersten Stromausgangsknoten 21 und damit zum Gleichstromverbraucher. Vom Gleichstromverbraucher fließt der Strom über den zweiten Stromausgangsknoten 22, den zweiten Trennschalter 8 und den zweiten Stromeingangsknoten 12 zurück zum Solargenerator 2.

Erfindungsgemäß wird die Eigenschaft eines Solargenerators genutzt, dass der maximale Strom des Solargenerators auf den Kurzschlussstrom begrenzt ist, der üblicherweise nur knapp über dem Nennstrom liegt.

Trenner können grundsätzlich nur eingesetzt werden, wenn über ihnen zum Schaltzeitpunkt keine Spannung anliegt oder durch sie kein Strom fließt.

Dass kein Strom fließt, gewährleistet das in Figur 1 dargestellte Hilfsschaltmittel 14, das gemäß einer Ausführungsform als Leistungsschalter ausgebildet ist. Schließt dieses Hilfsschaltmittel 14 bzw. der Leistungsschalter, so sperrt das als Diode ausgebildete Gleichrichtmittel 10, wenn am Verbraucher noch eine Spannung anliegt. Im Falle eines Wechselrichters als Gleichstromverbraucher weist dieser typischerweise einen Eingangskondensator auf, der die Spannung aufrechterhält. Im Grunde fließt nun der komplette vom Solargenerator 2 erzeugte Strom über das als Leistungshalbleiter ausgebildete Hilfsschaltmittel 14. Das Trennmittel 4, das als Trenner ausgeführt ist, kann stromlos öffnen. Die Schaltleistung wird vom Leistungshalbleiter bzw. Hilfsschaltmittel beim nachfolgenden Abschalten des Solargeneratorstromes übernommen.

Nachteilig an der Anordnung gemäß Figur 1 könnte angesehen werden, dass permanent eine Seriendiode, nämlich die Diode bzw. das Gleichrichtmittel 10, zum Solargenerator 2 im Eingriff ist. Der Spannungsabfall an der Diode 10 kann jedoch durch parallel geschaltete MOS-Schalter reduziert werden, die im Wesentlichen invers zu dem als Leistungshalbleiter ausgebildeten Hilfsschaltmittel 14 angesteuert werden.

Die vorliegend beschriebene Erfindung soll somit zur Reduktion von Kosten beitragen, indem der Einsatz von Trennern, wobei auch Trenner aus dem AC-Bereich verwendet werden können, statt DC-Leistungsschaltern ermöglicht wird.

Weitere Merkmale der Erfindung, insbesondere Vorteile, bestehen darin, dass keine oder eine geringe Belastung der Schaltkontakte des Trennmittels beim Abschalten auftritt. Zudem werden kostengünstige Lösungen dadurch ermöglicht, dass AC-Trenner genutzt werden können. Mitunter ist ein kompakterer Aufbau möglich, da für das Trennmittel kein Platz für Lichtbogenkammern und anderes benötigt wird. Im eingeschalteten Betrieb ist allenfalls mit geringen Verlusten zu rechnen, da nur - ausgehend von der Ausführungsform gemäß Figur 1 - die Diode 10 vom Strom durchflossen wird.

## Patentansprüche

1. Schaltungsanordnung (1) zum elektrischen Koppeln einer Gleichstromquelle (2) mit einem Gleichstromverbraucher, umfassend einen ersten und zweiten Stromeingangsknoten (11, 12) zum Aufnehmen eines von der Gleichstromquelle erzeugten Gleichstroms,
einen ersten und zweiten Stromausgangsknoten (21, 22) zum Abgeben des erzeugten Gleichstroms an den Gleichstromverbraucher,
ein zwischen dem ersten Stromeingangsknoten (11) und dem ersten Stromausgangsknoten (21) und/oder dem zweiten Stromeingangsknoten (12) und dem zweiten Stromausgangsknoten (22) angeschlossenes Trennmittel (4) zum Unterbrechen der elektrischen Verbindung zwischen den jeweiligen Knoten, und
ein zwischen dem ersten Stromeingangsknoten (11) und dem zweiten Stromeingangsknoten (12) angeschlossenes Hilfsschaltmittel (14) zum Kurzschließen des ersten und zweiten Stromeingangsknotens (11, 12), **dadurch gekennzeichnet, dass** als Trennmittel (4) ein AC-Trenner verwendet wird, wobei zwischen dem ersten Stromeingangsknoten (11) und dem ersten Stromausgangsknoten (21) und/oder zwischen dem zweiten Stromeingangsknoten (12) und dem zweiten Stromausgangsknoten (22) ein Gleichrichtmittel (10), insbesondere eine Diode angeordnet ist, um den erzeugten Gleichstrom zu leiten und eine Stromumkehr zu verhindern, und wobei parallel zum Gleichrichtmittel (10) wenigstens ein Halbleiterschalter, insbesondere MOS-Schalter, geschaltet ist.

2. Schaltungsanordnung (1) nach Anspruch 1, weiter umfassend eine an dem ersten und zweiten Stromeingangsknoten (11, 12) angeschlossene Gleichstromquelle (2), insbesondere Solargenerator (2), zum Erzeugen und Eingeben eines elektrischen Stroms und/oder ein an dem ersten und zweiten Stromausgangsknoten (21, 22) angeschlossener Gleichstromverbraucher zum Aufnehmen des erzeugten Gleichstroms, insbesondere ein Wechselrichter zum Wandeln des Gleichstroms in einen Wechselstrom zum Einspeisen in ein elektrisches Wechselstromnetzwerk.

3. Schaltungsanordnung (1) nach einem der vorstehenden Ansprüche, **dadurch gekennzeichnet, dass** das Hilfsschaltmittel (14) wenigstens einen Halbleiterschalter, insbesondere einen IGBT, Thyristor oder MOSFET umfasst, insbesondere dass das Hilfsschaltmittel ein Halbleiterschalter ist.

4. Verfahren zum Unterbrechen einer Gleichstromverbindung zwischen einem Ausgang einer Gleichstromquelle und einem Eingang eines Gleichstromverbrauchers unter Verwendung einer Schaltungsanordnung gemäß Anspruch 1, umfassend die Schritte:
- Kurzschließen des Ausgangs der Gleichstromquelle (2) mittels eines Hilfsschaltmittels {14), sodass am Ausgang der Gleichstromquelle (2) ein Kurzschlussstrom fließt und die Gleichstromverbindung stromlos wird,
- anschließendes Unterbrechen der Gleichstromverbindung und
- anschließendes Öffnen des Hilfsschaltmittels (14) um den Kurzschlussstrom am Ausgang der Gleichstromquelle (2) zu unterbrechen, **dadurch gekennzeichnet, dass** als Trennmittel (4) ein AC-Trenner verwendet wird.

5. Verfahren nach Anspruch 4, **dadurch gekennzeichnet, dass** eine Schaltungsanordnung (1) nach einem der Ansprüche 1 bis 3 verwendet wird.

6. Verwendung eines AC-Trenners zum Unterbrechen einer Gleichstromverbindung zwischen einem Ausgang einer Gleichstromquelle (2) und einem Eingang eines Gleichstromverbrauchers, wobei ein Hilfsschalter (14) zum Kurzschließen des Ausgangs der Gleichstromquelle vorgesehen ist, wobei
der AC-Trenner in einer Schaltungsanordnung (1) nach einem der Ansprüche 1 bis 3 verwendet wird.

## Claims

1. Circuit arrangement (1) for electrically coupling a direct-current source (2) to a direct-current load, comprising
a first and second current input node (11, 12) for receiving a direct current generated by the direct-current source,
a first and second current output node (21, 22) for delivering the generated direct current to the direct-current load,
a disconnecting means (4) connected between the first current input node (11) and the first current output node (21) and/or the second current input node (12) and the second current output node (22) and serving for interrupting the electrical connection between the respective nodes, and
an auxiliary switching means (14) connected between the first current input node (11) and the second current input node (12) and serving for short-circuiting the first and second current input node (11, 12), **characterized in that** an AC disconnector is used as disconnecting means (4), wherein a rectifying means (10), in particular a diode, is arranged between the first current input node (11) and the first current output node (21) and/or between the second current input node (12) and the second current output node (22), in order to conduct the generated direct current and to prevent a current reversal, and wherein at least one semiconductor switch, in particular MOS switch, is connected in parallel with the rectifying means (10).

2. Circuit arrangement (1) according to Claim 1, further comprising a direct-current source (2), in particular solar generator (2), connected to the first and second current input node (11, 12) and serving for generating and inputting an electric current and/or a direct-current load connected to the first and second current output nodes (21, 22) and serving for receiving the generated direct current, in particular an inverter for converting the direct current into an alternating current for feeding into an electrical alternating-current network.

3. Circuit arrangement (1) according to either of the preceding claims, **characterized in that** the auxiliary switching means (14) comprises at least one semiconductor switch, in particular an IGBT, a thyristor or MOSFET, in particular **in that** the auxiliary switching means is a semiconductor switch.

4. Method for interrupting a direct-current connection between an output of a direct-current source and an input of a direct-current load using a circuit arrangement according to Claim 1, comprising the following steps:
- short-circuiting the output of the direct-current source (2) by means of an auxiliary switching means (14), such that a short-circuit current flows at the output of the direct-current source (2) and the direct-current connection becomes currentless,
- subsequently interrupting the direct-current connection, and
- subsequently opening the auxiliary switching means (14) in order to interrupt the short-circuit current at the output of the direct-current source (2), **characterized in that** an AC disconnector is used as disconnecting means (4).

5. Method according to Claim 4, **characterized in that** a circuit arrangement (1) according to any of Claims 1 to 3 is used.

6. Use of an AC disconnector for interrupting a direct-current connection between an output of a direct-current source (2) and an input of a direct-current load, wherein provision is made of an auxiliary switch (14) for short-circuiting the output of the direct-current source, wherein
the AC disconnector is used in a circuit arrangement (1) according to any of Claims 1 to 3.

## Revendications

1. Arrangement de circuit (1) destiné à la connexion électrique d'une source de courant continu (2) avec un consommateur de courant continu, comprenant un premier et un deuxième noeud d'entrée de courant (11, 12) destinés à recevoir un courant continu généré par la source de courant continu,
un premier et un deuxième noeud de sortie de courant (21, 22) destinés à délivrer le courant continu généré au consommateur de courant continu,
un moyen de sectionnement (4) disposé entre le premier noeud d'entrée de courant (11) et le premier noeud de sortie de courant (21) et/ou le deuxième noeud d'entrée de courant (12) et le deuxième noeud de sortie de courant (22) servant à interrompre la liaison électrique entre les noeud respectifs, et
un moyen de commutation auxiliaire (14) disposé entre le premier noeud d'entrée de courant (11) et le deuxième noeud d'entrée de courant (12) servant à court-circuiter le premier et le deuxième noeud d'entrée de courant (11, 12),
**caractérisé en ce que** le moyen de sectionnement (4) utilisé est un sectionneur de CA, un moyen de redressement (10), notamment une diode, étant disposé entre le premier noeud d'entrée de courant (11) et le premier noeud de sortie de courant (21), et/ou entre le deuxième noeud d'entrée de courant (12) et le deuxième noeud de sortie de courant (22) afin de conduire le courant continu généré et empêcher un retournement du courant, et au moins un commutateur à semiconducteur, notamment un commutateur MOS, étant branché en parallèle avec le moyen de redressement (10).

2. Arrangement de circuit (1) selon la revendication 1, comprenant en outre une source de courant continu (2), notamment un générateur solaire (2), raccordée au premier et au deuxième noeud d'entrée de courant (11, 12), servant à générer et à injecter un courant électrique et/ou un consommateur de courant continu raccordé au premier et au deuxième noeud de sortie de courant (21, 22) destiné à recevoir le courant continu généré, notamment un onduleur destiné à convertir le courant continu en un courant alternatif destiné à être injecté dans un réseau électrique à courant alternatif.

3. Arrangement de circuit (1) selon l'une des revendications précédentes, **caractérisé en ce que** le moyen de commutation auxiliaire (14) comprend au moins un commutateur à semiconducteur, notamment un IGBT, un thyristor ou un MOSFET, notamment **en ce que** le moyen de commutation auxiliaire est un commutateur à semiconducteur.

4. Procédé d'interruption d'une liaison à courant continu entre une sortie d'une source de courant continu et une entrée d'un consommateur de courant continu en utilisant l'arrangement de circuit selon la revendication 1, comprenant les étapes suivantes :
- court-circuit de la sortie de la source de courant continu (2) à l'aide d'un moyen de commutation auxiliaire (14), de sorte qu'un courant de court-circuit circule à la sortie de la source de courant continu (2) et que la liaison à courant continu soit hors tension,
- ensuite interruption de la liaison à courant continu et
- ensuite ouverture du moyen de commutation auxiliaire (14) afin d'interrompre le courant de court-circuit à la sortie de la source de courant continu (2), **caractérisé en ce que** le moyen de sectionnement (4) utilisé est un sectionneur de CA.

5. Procédé selon la revendication 4, **caractérisé en ce qu'**un arrangement de circuit (1) selon l'une des revendications 1 à 3 est utilisé.

6. Utilisation d'un sectionneur de CA pour interrompre une liaison à courant continu entre une sortie d'une source de courant continu (2) et une entrée d'un consommateur de courant continu, un commutateur auxiliaire (14) étant présent pour court-circuiter la sortie de la source de courant continu, le sectionneur de CA étant utilisé dans un arrangement de circuit (1) selon l'une des revendications 1 à 3.
